(19) Europäisches Patentamt
European Patent Office
Office européen des brevets

(11) **EP 1 443 336 B1**

(12) **EUROPÄISCHE PATENTSCHRIFT**

(45) Veröffentlichungstag und Bekanntmachung des Hinweises auf die Patenterteilung:
**17.10.2007 Patentblatt 2007/42**

(51) Int Cl.:
*G01R 31/28* (2006.01)    *G01R 31/08* (2006.01)
*G01R 31/02* (2006.01)

(21) Anmeldenummer: **04004802.7**

(22) Anmeldetag: **17.11.1999**

(54) **Verfahren zur Bestimmung des erdschlussbehafteten Abzweiges**

Method of detecting a branch with an earth fault

Procédé de détection d'un branchement présentant une perte à terre

(84) Benannte Vertragsstaaten:
**AT CH DE FR IT LI**

(30) Priorität: **20.11.1998 AT 194698**

(43) Veröffentlichungstag der Anmeldung:
**04.08.2004 Patentblatt 2004/32**

(62) Dokumentnummer(n) der früheren Anmeldung(en) nach Art. 76 EPÜ:
**99963307.6 / 1 131 642**

(73) Patentinhaber: **Adaptive Regelsysteme Gesellschaft mbH**
**5020 Salzburg (AT)**

(72) Erfinder: **Leikermoser, Albert**
**5020 Salzburg (AT)**

(74) Vertreter: **Weiss, Christian et al**
**Klein, Pinter & Laminger OEG**
**Prinz-Eugen-Straße 70**
**1040 Wien (AT)**

(56) Entgegenhaltungen:
WO-A-92/18872        WO-A-96/27138
US-A- 5 825 189

- **LEITHOFF V ET AL: "Messung der Parameter eines kompnesierten Netzes durch Injektion eines Stromes in den Sternpunkt" ELEKTRIZITAETSWIRTSCHAFT, VEREINIGUNG DEUTSCHER ELEKTRIZITAETZSWERKE, FRA, DE, Bd. 93, Nr. 22, 1994, Seiten 1371-1372,1374, XP002102033 ISSN: 0013-5496**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die vorliegende Erfindung bezieht sich auf ein Verfahren und eine Vorrichtung zur Bestimmung eines erdschlußbehafteten Abzweiges in einem induktiv sternpunktkompensierten elektrischen Stromversorgungsnetz, wobei als Messgrößen zumindest die Verlagerungsspannung oder die Summe der Phasen-Erdspannungen der einzelnen Phasen und die Nullströme aller Abzweige oder die Summe der einzelnen Phasenströme dieser Abzweige oder gleichwertige Messgrößen ausgewählt und gemessen werden.

Zur Bestimmung eines erdschlußbehafteten Abzweiges in einem gelöschten elektrischen Stromversorgungsnetz ist eine Anzahl von unterschiedlichen Verfahren bekannt, die z.B. in der WO92/18872, der EP 82103, der DE 27 11 629 oder der WO96/27138, aber auch in der Fachliteratur, z.B. Schutztechnik in elektrischen Netzen, VDE Verlag, ISBN 3-8007-1498-1, ausführlich beschrieben sind. Jedes dieser Verfahren hat jedoch bestimmte Nachteile, z.B. können mit einigen Verfahren keine kurzzeitigen Erdschlüsse erkannt werden, wogegen bei anderen Verfahren beispielsweise keine hochohmigen Erdschlüsse erkannt werden können.

Die EP 267 500 A1 beschreibt eine einfache Erdschlußerkennung mittels eines transienten Auswerteverfahrens, bei welchem zwei Teilverfahren angewendet werden, wobei bei jedem Verfahren ein Messsignal gewonnen wird. Jedes Messsignal erzeugt bei Überschreiten eines vorgegebenen Schwellenwertes ein Meldesignal (siehe z.B. Spalte 4, Zeile 5ff), das als Erfülltheitsgrad im Sinne einer zweiwertigen Logik betrachtet werden kann. Es wird in der Folge die Phasenbeziehung zwischen den Transienten der beiden Meldesignale und daraus die Richtung des Erdschlusses bestimmt.

In der US 5 839 093 A sind zwei numerische Verfahren unter Berücksichtigung der Lastströme zur Bestimmung des Fehlerortes in einem elektrischen Verteilnetz beschrieben. Dieses Verfahren dient wie das vorgenannte Verfahren zur Entfernungsbestimmung und nicht zur Bestimmung eines erdschlußbehafteten Abzweigs.

In der US 4 351 011 A ist ein Verfahren zur Erkennung der Richtung eines Erdschlusses relativ zum Messort beschrieben, bei welchem das Vorzeichen des Produktes aus Spannung und Strom zur Erkennung herangezogen wird.

Es ist daher eine Aufgabe der vorliegenden Erfindung, ein neuartiges Verfahren zu schaffen, bei welchem die Nachteile bekannter Verfahren vermieden werden und welches sich insbesondere durch eine hohe Verfahrenssicherheit auszeichnet, bei welchem jedoch kein wesentlicher zusätzlicher gerätetechnischer Aufwand entsteht und folglich keine Mehrkosten verursacht werden: Insbesondere ist es ein Ziel der Vorliegenden Erfindung, ein Verfahren zu schaffen, welches besonders kurzzeitige Erdschlüsse mit großer Zuverlässigkeit erfassen und anzeigen kann.

Diese Aufgabe wird durch ein Verfahren gelöst, welches den transienten Umladevorgang über eine Erdschlussstelle auswertet, indem unter Verwendung eines Leitungsmodells mit konzentrierten Parametern für das elektrische Versorgungsnetz eine funktionale Beziehung zwischen den zeitlichen Integralen der Abzweignullströme $i_0$, bzw. den zeitlichen Integrale der Summe der einzelnen Phasenströme $i_1$, $i_2$, $i_3$, und der Verlagerungsspannung $U_{ne}$, bzw. den Phasen-Erdspannungen $U_{1e}$, $U_{2e}$, $U_{3e}$, hergestellt wird und die durch den transienten Umladevorgang über eine eventuell vorhandene Erdschlussstelfe beeinflusste funktionale Beziehung zwischen den zeitlichen Integralen der Abzweignullströme $i_0$, bzw. zeitlichen Integrale, der Summe der einzelnen Phasenströme $i_1$, $i_2$, $i_3$, und der Verlagerungsspannung $U_{ne}$, bzw. den Phasen-Erdspannungen $U_{1e}$, $U_{2e}$, $U_{3e}$, zur Bestimmung eines erdschlußbehafteten Abzweiges ausgewertet wird.

Das Verfahren, bei dem die transienten Umladevorgänge bei Erdschluss ausgewertet werden, ist besonders für die Auswertung von Erdschlusswischern, also sehr kurzfristigen Erdfehlern, geeignet. Das Verfahren wertet den transienten Umladevorgang aus und erkennt daher Erdschlüsse auch dann, wenn diese nur sehr kurz, z.B. ca. 1 bis 2 Millisekunden, bestehen. Da dazu nur Messgrößen verwendet werden, die in der Regel sowieso in einer oder anderer Form erfasst werden, hält sich auch der gerätetechnische Aufwand sehr in Grenzen. Als Messgrößen, welche durch die Methoden ausgewertet werden, sind zumindest die Sternpunkt-Erdspannung oder die Summe der Erdspannungen der einzelnen Phasen und die Nullströme oder die Summe der einzelnen Phasenströme dieser Abzweige oder gleichwertiger Messgrößen von besonderem Vorteil.

Besonders vorteilhaft erfolgt die Auswertung unter Einbeziehung signifikanter Abzweigparameter, z.B. der Summe der ohmschen G und/oder kapazitiven Ableitungen C, wobei besonders die für einen Abzweig geltenden grundlegenden Beziehung $I_{in}(t) \approx \llcorner (I_{it}(t) \cdot G + dU_{nt}(t) \cdot C) + (I_{if}(t)) \lrcorner$, gegebenenfalls im Zeitbereich, geeignet ist.

Das erfindungsgemäße Verfahren lässt sich wesentlich vereinfachen, wenn zur Auswertung der Gleichanteil eines Fehlerstromintegrales für die Abzweige berechnet wird und ein Abzweig als erdschlussbehaftet erkannt wird, wenn ein Gleichanteil des ermittelten Fehlerstromintegrals vorhanden ist bzw. dessen Gleichanteil am größten ist.

Die signifikanten Abzweigparameter lassen sich sehr einfach im erdschlußfreien Netz bestimmen, z.B. durch die Auswertung von Messwerten bei unterschiedlichen Verlagerungsspannungen $U_{ne}$.

Die Ermittlung eines fehlerhaften Abzweiges kann wesentlich vereinfacht werden, wenn der Gleichanteil des Nullstromintegrales nur zu Zeitpunkten berechnet wird, für die die Vertagerungsspannung $U_{ne}$ gleich Null ist, da dann im zeitlichen Integral des Abzweignullstromes nur der Gleichanteil des Fehlerstromintegrales übrig bleibt und der von der Abzweigkapazität verursachte Wechselanteil verschwindet. Der Gleichanteil des Fehlerstromintegrals lässt sich besonders einfach als arithmetisches Mittel von gegen Ende der Aufzeichnungsperiode ermittelten Nullstromintegral-Wertepaare bilden. Der Vorteil bei dieser Verfahrensvariante liegt unter anderem auch darin, dass keine Information über die kapazitiven Ableitungen erforderlich ist, sondern lediglich jene über die ohmschen Ableitungen.

Eine einfache Bestimmung eines fehlerhaften Abzweigs kann mittels eines Erfülltheitsgrads für das Vorliegen eines Erdschlusses durchgeführt werden, die z.B. als relative Fehlerfunktion festgelegt wird, und vorzugsweise auf Werte zwischen null und eins normiert wird. Damit reduziert sich die Erkennung eines fehlerhaften Abzweigs darauf, festzustellen, wie nahe der Erfülltheitsgrad bei eins liegt.

Zusammengefasst, ergibt sich eine vorteilhafte Methode zur Bestimmung des erdschlußbehafteten Abzweiges eines induktiv sternpunktkompensierten Netzes dadurch, dass anhand eines Leitungsmodells für jeden Abzweig der transiente Umladevorgang nach Eintritt des Erdschlusses, gegebenenfalls unter Einbeziehung von Meßgrößen, die vor Eintritt des Erdschlusses ermittelt werden, ausgewertet wird. Mit dieser Methode, bei welcher die spannungsmäßigen Umladungen der Phasen-Erdkapazitäten der einzelnen Leiter des Gesamtnetzes ausgewertet werden, lassen sich insbesondere kurzzeitige Erdschlüsse, sogenannte Erdschluß-Wischer erkennen und auswerten. Bei dieser Methode hat es sich als vorteilhaft erwiesen, dass die Auswertung des transienten Umladevorganges durch Auswertung der Sternpunkt-Erdspannung oder der Phasen-Erdspannungen und der Nullströme oder der Summe der einzelnen Phasenströme aller Abzweige durchgeführt und gegebenenfalls unter Einbeziehung signifikanter Abzweigparameter, z.B. der Summe der ohmschen und/oder kapazitiven Ableitungen, sowie gegebenenfalls einer im störungsfreien Netzbetrieb ermittelten Leitungsübertragungsfunktion, der Gleichanteil des Nullstromintegrales für jeden Abzweig berechnet und daraus der Erfülltheitsgrad für das Vorliegen eines Erdschlusses ermittelt wird. Die signifikanten Abzweigparameter können im erdschlußfreien Fall bei zwei unterschiedlichen Verlagerungsspannungen, z.B. bei zwei verschiedenen Stellungen der Löschspule, bestimmt werden, wobei die Summe der ohmschen und/oder der kapazitiven Ableitungen durch Fourierreihenentwicklung der Grundwelle, und gegebenenfalls einer Leitungsübertragungsfunktion aus der Fourierreihenentwicklung der Grundwelle, sowie zumindest einer Oberwelle der Meßgrößen ermittelt werden.

Eine Vereinfachung dieses Verfahrens ergibt sich dadurch, dass die Nullstromintegrale zu paarweisen Zeitpunkten berechnet werden, bei welchen die Sternpunkt-Erdspannung gleich Null ist, und der Gleichanteil des Fehlerstromintegrales aus einem zu diesen Zeitpunkten ermittelten Nullstromintegral - Wertepaar gebildet und zur Festlegung des Erfülltheitsgrades für das Vorliegen eines Erdschlusses herangezogen wird. Die Zeitpunktpaare sind zeitlich um eine halbe Periode der Sternpunkt-Erdspannung voneinander getrennt und werden vorzugsweise zum Ende des transienten Umladevorganges bestimmt. Der Vorteil bei dieser Verfahrensvariante liegt unter anderem darin, dass keine Information über die kapazitiven Ableitungen erforderlich ist, sondern höchstens jene über die ohmschen Ableitungen. Der Erfülltheitsgrad für das Vorliegen eines Erdschlusses wird vorzugsweise mittels einer relativen Fehlerfunktion, z.B. der Gleichanteil des Fehlerstromintegrales bezogen auf die Summe der Gleichanteile aller Abzweige, festlegt, sodass die Erfülltheitsgrade im Sinne einer Logik bereits zwischen 0 und 1 normiert sind und in dieser Form weiterverarbeitet werden können.

Nachfolgend wird ohne Einschränkung die vorliegende erfinderische Methode zur Bestimmung eines erdschlußbehafteten Abzweiges, sowie eine Vorrichtung zur Durchführung des erfindungsgemäßen Verfahrens im Detail beschrieben, wobei auf die beiliegenden Figuren 1 bis 3 Bezug genommen wird, von welchen

Figur 1    den Aufbau eines gelöschten elektrischen Versorgungsnetzes,
Figur 2    ein Leitungsmodell zur Nachbildung dieses Netzes und
Figur 3    ein Blockschaltbild für eine erfindungsgemäße Einrichtung zeigt.

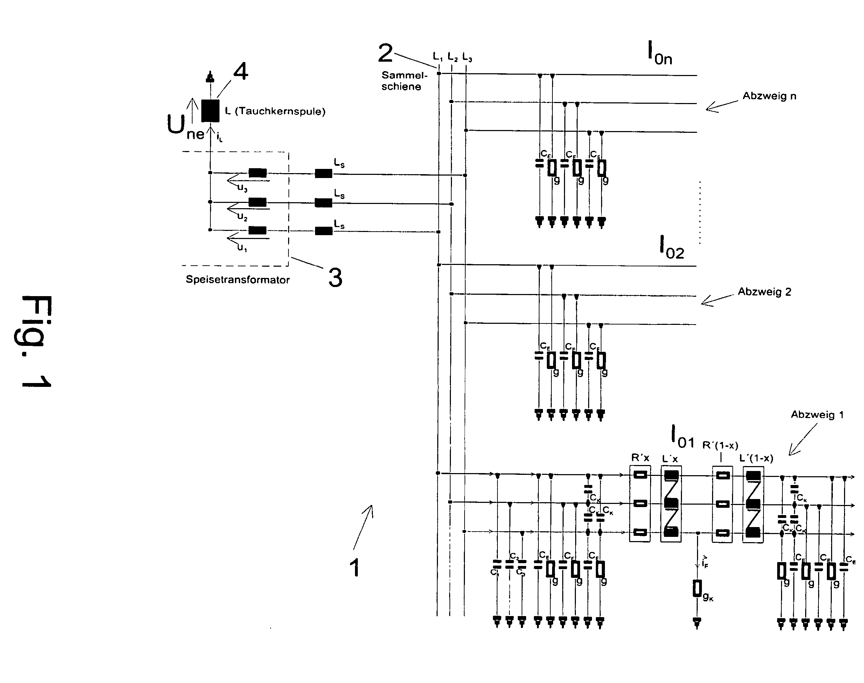

Das in Figur 1 dargestellte Versorgungsnetz 1 weist eine dreiphasige Sammelschiene 2 auf, welche von einem Transformator 3 gespeist wird, dessen Sternpunkt über eine Löschdrossel 4, z.B. eine Tauchkernspule, deren Induktivität i.a. auf den Resonanzpunkt der Verlagerungsspannung $U_{ne}$ abgestimmt werden kann, geerdet ist, also ein gelöschtes bzw. induktiv sternpunktkompensiertes Versorgungsnetz. Verbraucherseitig sind an der Sammelschiene 2 mehrere Abzweige 1, 2, ...n angeschlossen, welche jeweils ohmsche g und kapazitive Ableitungen C, sowie Längswiderstände und -induktivitäten aufweisen. An der Phase $L_3$ des Abzweiges 1 ist am Ort x ein Erdschluß mit dem ohmschen Leitwert $g_k$ angedeutet, über welchen der Fehlerstrom $I_F$ fließt.

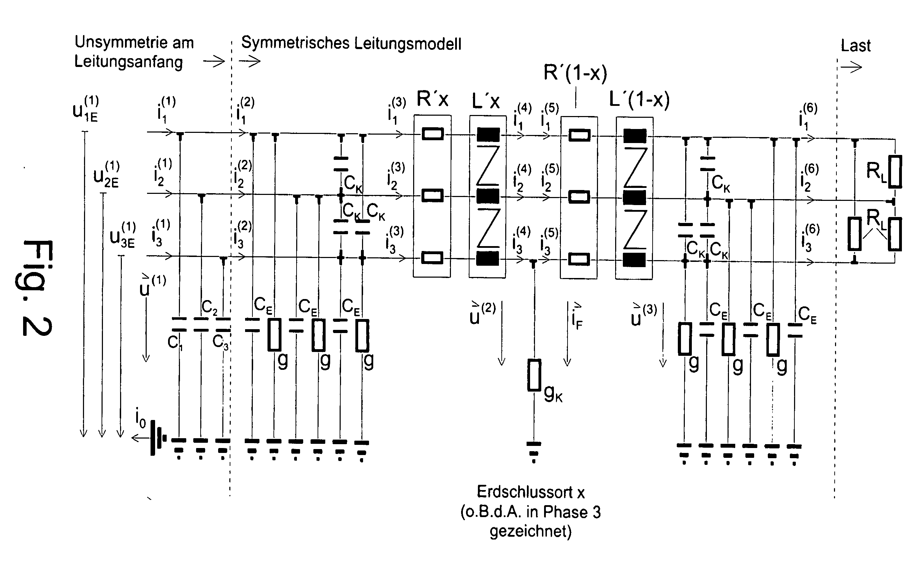

In Figur 2 ist das den Berechnungen zugrunde gelegte Leitungsmodell näher dargestellt. Zur Behandlung von einpoligen Erdschlüssen in gelöschten Mittel- und Hochspannungsleitungen ist es grundsätzlich notwendig, für die weiteren Betrachtungen ein geeignetes Modell (Ersatzschaltbild) der Leitung zu entwerfen. Die Struktur des Modells hängt stark vom betrachteten Frequenzspektrum ab. Grundsätzlich ist eine Leitung im gesamten Frequenzspektrum nur durch ein System mit verteilten Parametern beschreibbar.

Bei Einschränkung des Frequenzbereiches von 0 Hz bis ca. 400 Hz kann das Ersatzschaltbild gemäß Figur 2 als gute Näherung verwendet werden. Dieses Leitungsmodell enthält keine verteilten, sondern nur konzentrierte Parameter, die unabhängig von den fließenden Strömen bzw. Spannungen sind. Daher ist dieses Leitungsmodell auch linear. Diese Eigenschaft ist von grundlegender Bedeutung für die nachfolgenden Betrachtungen.

Zwecks Vereinfachung werden die Unsymmetrien der Leitungsgrößen auf den Leitungsanfang konzentriert.

Ferner werden aufgrund der besseren Übersichtlichkeit die Lastwiderstände gleich und ohmsch (also ohne induktive Komponente) angenommen. Diese beiden Vereinfachungen haben jedoch keinen großen Einfluß auf das Ergebnis.

Das nachstehend beschriebene Verfahren dient einerseits zur Bestimmung des erdschlußbehafteten Abzweiges (Erdfehler einer Phase) und liefert andererseits Aussagen über das Vorhandensein eines Erdschlusses im gelöschten Gesamtnetz.

Das beschriebene Verfahren setzt als Messgrößen die drei Phasen-Erdspannungen $U_{1e}$, $U_{2e}$, $U_{3e}$ oder die Sternpunkt-Erdspannung (oder Verlagerungsspannung) $U_{ne}$ und die Messung der Nullströme aller Abzweige ($I_{01}$, $I_{02}$, ..., $I_{0n}$) oder als Ersatz für einen Abzweignullstrom die Summe der Phasenströme $i_1$, $i_2$, $i_3$ dieses Abzweigs voraus, gegebenenfalls in leicht abgewandelter Form, z.B. die Abtastung einer Messgröße in äquidistanten Zeitabständen, die Messung einer Grundwelle und/oder einer oder mehrerer Oberwellen dieser Messgrößen in Betrag und Phase bezüglich einer zeitlichen Referenzgröße.

Statt der Sternpunkt-Erdspannung bzw. Verlagerungsspannung $U_{ne}$ kann alternativ das arithmetische Mittel der drei Phasen-Erdspannungen (($U_{1e}$ + $U_{2e}$ + $U_{3e}$)/3) verwendet werden.

Das nachstehend beschriebene Verfahren ist zur Auswertung besonders kurz andauernder Erdschlüsse (Erdschluß-Wischer) geeignet und wird daher als Wischer-Verfahren bezeichnet.

Aus theoretischen Überlegungen läßt sich die Laplace Transformierte des Abzweignullstromes $I_0(p)$ bzw. der (dem Nullstrom gleichwertigen) Summe der Phasenströme $i_1$, $i_2$, $i_3$ des Abzweigs in Abhängigkeit von der Laplace Transformierten der Verlagerungsspannung $U_{ne}(p)$ bzw. dem (der Verlagerungsspannung gleichwertigen) arithmetischen Mittel der Phasen-Erdspannungen (($U_{1e}$+$U_{2e}$+$U_{3e}$)/3)(p)), sowie der Laplace Transformierten des Stromes an der Fehlerstelle $I_f(p)$ für jeden Abzweig durch nachfolgende Gleichung beschreiben:

$$I_0(p) = \left(U_{ne}(p) \cdot (G + p \cdot C) \cdot F_1(p)\right) + \left(I_f(p) \cdot F_2(p,x)\right) \tag{1}$$

wobei:

$I_0(p)$    Laplace Transformierte des Abzweignullstromes,
$U_{ne}(p)$    Laplace Transformierte der Verlagerungsspannung,
$If(p)$    Laplace Transformierte des Stromes an der Erdschlußstelle (Fehlerstrom),
$G$    Summe der Ohmschen Ableitungen des Abzweiges,
$C$    Summe der Phasen-Erdkapazitäten des Abzweiges,
$F_1(p)$    eine für jeden Abzweig spezifische, gebrochen rationale Übertragungsfunktion des gesunden Abzweiges, die aus Messungen im gesunden Netz mittels Fouriertransformation bzw. Fourierreihenentwicklung bestimmbar ist, und
$F_2(p)$    eine vom Fehlerort x abhängige Übertragungsfunktion, welche die Auswirkung des Fehlerstromes auf den Abzweignullstrom beschreibt.

Setzt man für x die halbe Leitungslänge 1/2 ein, ergibt dies in guter Näherung:

$$I_0(p) \approx \left[\left(U_{ne}(p) \cdot (G + p \cdot C)\right) + \left(I_f(p)\right)\right] \cdot F_1(p) \tag{2}$$

$F_1(p)$ kann als eine gebrochen rationale Funktion, d.h. als Bruch zweier Polynome der komplexen Frequenzvaraiablen p dargestellt werden. Demnach kann die Umkehrfunktion $H(p)$ von $F_1(p)$ als Vertauschung von Zähler und Nenner dieses Bruchs ermittelt werden. Daraus folgt:

$$\left[I_0(p) \cdot H(p)\right] = I_{0a}(p) \approx \left[\left(U_{ne}(p) \cdot (G + p \cdot C)\right) + I_f(p)\right]$$

wobei $I_{0a}(p)$ als das Ergebnis einer das Übertragungsglied $H(p)$ durchlaufenden Eingangsgröße $I_0(p)$ interpretiert werden kann. Bei Rücktransformation in den Zeitbereich, bei welcher eine durch p geteilte Größe dem zeitlichen Integral der Rücktransformierten der ursprünglichen Größe entspricht, folgt daraus:

**4**

$$I_{ia}(t) \approx \left| \left( I_u(t) \cdot G + dU_{ne}(t) \cdot C \right) + \left( I_{if}(t) \right) \right| \tag{3}$$

wobei:

$I_{ia}(t)$      Integral von 0 bis t des Stromes $I_{oa}(t)$,

$I_{if}(t)$      Integral von 0 bis t des Fehlerstromes $I_f(t)$,

$I_{io}(t)$      Integral von 0 bis t des Stromes $I_o(t)$

$I_u(t)$      Integral von 0 bis t der Verlagerungsspannung $U_{ne}(t)$ und

$dU_{ne}(t)$      $= U_{ne}(t) - U_{ne}(0)$ ist.

Die obige Gleichung gibt an, dass sich $I_{ia}(t)$ als Integral des Stromes $I_{oa}(t)$ im Zeitbereich als Ausgangsgröße der das lineare Übertragungsglied H(p) durchlaufenden Eingangsgröße $I_{i0}(t)$ ergibt, welche jedoch dem Integral des Abzweignullstromes $I_0(t)$ entspricht. Werden sowohl die Verlagerungsspannung $U_{ne}(t)$ als auch die Abzweignullströme $I_0(t)$ für jeden Abzweig zu äquidistanten Zeitpunkten gemessen (z.B. abgetastet), so können deren jeweilige Integrale numerisch berechnet werden.

Durch Bilineartransformation kann die z-Transformierte der Übertragungsfunktion H(z) ermittelt werden. Demnach kann die Größe $I_{ia}(t)$ durch rekursive Filterung der Abzweignullstromintegrale mit dem durch die Funktion H(z) definierten digitalen rekursiven Filter berechnet werden $I_{ia}(z) = I_{i0}(z)H(z)$. Durch Kenntnis von $I_{ia}(z)$ sind die Werte für $I_{ia}(t)$ für äquidistante Zeitpunkte festgelegt.

Von den in Gleichung (3) angeführten Größen sind nun lediglich G, C und $I_f(t)$ unbekannt. Ein Vergleich von G mit C zeigt, dass die durch C verursachten Nullstromintegralanteile wesentlich dominieren. G kann aus dem Betrieb des Netzes im erdschlußfreien Fall ausreichend genau bestimmt werden.

Bei Anwendung des Verfahrens wird vor Eintritt eines Erdschlusses ein Abtastzeitpunkt ts0 gefunden, bei welchem die Spannung $U_{ne} = 0$ ist, und zum Referenzzeitpunkt t=0 erklärt. Nach Eintritt eines Erdschlusses sind ebenso jene Abtastzeitpunkte tsj (j=1, 2,..m) zu finden, bei welchen die Spannung $U_{ne} = 0$ ist. Falls die Abtastfrequenz zu gering ist, können die gewünschten Größen durch Interpolation ermittelt werden. Demnach ergibt sich für diese Abtastzeitpunkte, bei denen die durch C verursachten Nullstromintegralanteile eliminiert werden, aus Gleichung (3)

$$I_{ia}(tsj) - I_u(tsj) \cdot G \approx I_{if}(tsj) \tag{4}$$

für j = 1, 2, 3, ..., m.

Daher ist das Fehlerstromintegral $I_{if}(t)$ in diesem Fall auch ohne Kenntnis von C eindeutig bestimmbar, wenn Abtastwertefolgen im Zeitraum von mindestens 10ms vor Erdschlußeintritt bis einige hundert ms nach Erdschlußeintritt bekannt sind und die Übertragungsfunktion $F_1(p)$ und die Summe der Ohmschen Ableitungen G im gesunden Netz bestimmt wurde.

Die Verarbeitung des Modells für den transienten Einschwingvorgang ergibt wesentliche Erkenntisse:

Im, durch den Term $I_u(tsj) \cdot G$ korrigierten, Nullstromintegral gesunder Abzweige ist kein Gleichanteil enthalten. Das Fehlerstromintegral, bzw. das durch den Term $I_u(tsj) \cdot G$ korrigierte Nullstromintegral, des erdschlußbehafteten Abzweiges besitzt neben einem Wechselanteil auch einen Gleichanteil, der sich aus der Umladung der Erdkapazitäten des Gesamtnetzes über die Fehlerstelle ergibt. Der Wechselanteil des Fehlerstromintegrales setzt sich aus einem Grundwellenanteil, den ungeradzahligen Oberwellenanteilen des Netzes und aperiodisch abklingenden höherfrequenten Anteilen, die von den Streuinduktivitäten des Speisetransformators und den Leitungskapazitäten verursacht werden, zusammen. Da der höherfrequente Anteil rasch abklingt, kann davon ausgegangen werden, dass gegen Ende des Aufzeichnungsintervalles nur noch ein Geichanteil, sowie die Grundwelle und die Oberwellen vorhanden sind, d.h., dass der Wechselanteil des Fehlerstromintegrals periodisch ist.

Gegen Ende des Aufzeichnungsintervalles gibt es demnach zwei Zeitpunkte, zu welchen $U_{ne}(t)$ gleich null ist und deren Abstand annähernd gleich einer halben Periodendauer der Grundwelle entspricht. Zu diesen Zeitpunkten werden die Nullstromintegrale berechnet. Aufgrund der Periodizität des Fehlerstromintegrales kann geschlossen werden, dass das arithmetische Mittel des Wertepaares genau dem Gleichanteil des Fehlerstromintegrales entspricht. Als erdschlußbehaftet wird grundsätzlich jener Abzweig ausgewiesen, dessen Gleichanteil des Fehlerstromintegrals maximal ist.

Das oben anhand des Modells beschriebene Verfahren wird nachfolgend anhand konkreter Verfahrensschritte erläutert.

Das Wischerverfahren benötigt jeweils zwei - vor und nach einer Änderung der Verlagerungsspannung, z.B. durch Stromeinspeisung in den Sternpunkt oder durch Verstellung der Löschspule - durchgeführte Messungen in einem nicht erdschlußbehafteten (gesunden) Netz. Aus diesen beiden Messungen werden für den jeweiligen Leitungsabgang die den Abzweig beschreibenden signifikanten Leitungsparameter G, C, $F_i(t)$ berechnet. Diese Parameter werden dann im Erdschlußfall zur Abzweigbestimmung benötigt.

Im gesunden (erdschlußfreien) Netz werden folgende Verfahrensschritte ausgeführt:

1) Messung, Berechnung der Fourierreihenentwicklung und Speicherung eines ersten Messwertsatzes, bestehend aus der Grundwelle und der Oberwellen der Verlagerungsspannung $U_{ne}(1)$ oder der Phasen-Erdspannungen $U_{1e}(1)+U_{2e}(1)+U_{3e}(1)$ und der Nullströme $I_{0i}(1)$ bzw. der Summe der Phasenströme $i_1$, $i_2$, $i_3$ aller Abgänge in Betrag und Phase, gemessen mit einer Abtastfrequenz im Kilohertzbereich, die einem ganzzahligen Vielfachen der Grundwelle der Netzfrequenz entspricht, über eine Messzeit, die sich aus einem ganzzahligen Vielfachen der Periodendauer der Netzfrequenz ergibt.

2) Änderung der Verlagerungsspannung, z.B. durch Veränderung der Sternpunktimpedanz, oder Stromeinspeisung, beispielsweise mit Hilfe eines Transduktors, über die Leistungshilfswicklung der Tauchkernspule.

3) Messung, Berechnung der Fourierreihenentwicklung und Speicherung eines zweiten Messwertesatzes bestehend aus der Grundwelle und der Oberwellen der Verlagerungsspannung $U_{ne}(2)$ oder der Phasen-Erdspannungen $U_{1e}(2)+U_{2e}(2)+U_{3e}(2)$ und der Nullströme $I_{0i}(2)$ bzw. der Summe der Phasenströme $i_1$, $i_2$, $i_3$ aller Abgänge in Betrag und Phase, gemessen mit einer Abtastfrequenz im Kilohertzbereich, die einem ganzzahligen Vielfachen der Grundwelle der Netzfrequenz entspricht, über eine Messzeit, die sich aus einem ganzzahligen Vielfachen der Periodendauer der Netzfrequenz ergibt.

4) Bestimmen der Summe der Ohmschen Ableitungen $G_i$, welche dem Realteil der sogenannten Nulladmittanz $Y_i$ entspricht, welche bzgl. der Grundwellenanteile aus der Differenz der Verlagerungsspannungen $DU_{ne}=(U_{ne}(2)-U_{ne}(1))$, sowie der Grundwellenanteile der Nullstromdifferenzen $DI_{0i}=(I_{0i}(2)-I_{0i}(1))$ berechnet wird mit $Yi=DI_{0i}/DU_{ne}$.

5) Im störungsfreien Betrieb werden diese Messungen und die Bestimmung von $G_i$ zyklisch wiederholt, sowie nach einem vorgegebenen Algorithmus die Leitungs-übertragungsfunktionen $F_1(p)$ bzw. $H(p)$ bzw. $H(z)$ bestimmt. Im Erdschlußfall, welcher durch eine plötzliche Änderung der Verlagerungsspannung oder eines Abzweignullstromes vermutet werden kann, werden folgende Verfahrensschritte durchgeführt:

6) Ab diesem Zeitpunkt wird eine definierte Anzahl von Abtastungen weiter gemessen und aufgezeichnet, ohne dass die zuvor während eines Zeitraumes von mindestens einer halben Periode (z.B. 10ms) gemessenen Werte überschrieben werden.

7) Nach Durchführung der Messwertaufzeichnung wird (z.B. durch Interpolation) ein vor Erdschlußeintritt liegender Zeitpunkt ts0 ermittelt, bei welchem $U_{ne}(ts0) = 0$ ist und als Referenzzeitpunkt t=0 erklärt.

8) Anschließend werden die Integrale der Verlagerungsspannung und aller Nullströme beginnend bei ts0 berechnet. Das Integral der Nullströme wird gegebenenfalls mit seiner spezifischen Korrekturfuktion $H(p)$ bzw. $H(z)$ korrekturgerechnet.

9) Es werden die Menge der Abtastzeitpunkte tsj bestimmt, gegebenenfalls durch Interpolation, bei welchen $U_{ne}(tsj) = 0$ ist.

10) Für alle Abzweige ist nun gemäß Gleichung (4) die Differenz der korrekturgerechneten Nullstromintegrale $I_{l0}$ mit dem Produkt des Verlagerungsspannungsintegrales $I_u$ mal der Summe der ohmschen Ableitungen $G_i$ zu bilden. Die Resultate der Berechnungen werden entsprechend den Zeitpunkten ts0, ....tsj in einer Tabelle hinterlegt. Es werden nun jene am Ende der Aufzeichnungsperiode liegende Zeitpunktpaare festgelegt, zu welchen $U_{ne} = 0$ ist und deren Zeitdifferenz bezogen auf die Netzfrequenz genau eine halbe Periodendauer beträgt, so dass sich die Wechselanteile der Nullstromintegrale kompensieren und als Ergebnis nur die Gleichanteile übrig bleiben.

11) Für die obigen Zeitpunktpaare wird das arithmetische Mittel der zugehörigen Fehlerstromintegrale für jeden Abzweig ermittelt und in einer Tabelle hinterlegt. Nicht erdschlußbehaftete Abzweige weisen keinen Gleichanteil auf, wogegen erdschlußbehaftete Abzweige, bedingt durch den Umladevorgang der Leitungs-Erdkapazitäten des gesamten Netzes über die Erdschlußstelle einen Gleichanteil aufweisen.

12) Falls Fehlerstromintegrale für mehrere Abzweige einen Gleichanteil aufweisen, kann das Ergebnis durch Bestimmung eines Erfülltheitsgrades (Wahrscheinlichkeit) p für das Vorliegen eines Erdschlusses an einem bestimmten Abgang verifiziert werden, indem der Quotient aus dem Absolutbetrag des Gleichanteiles und der Summe der Absolutbeträge der Gleichanteile aller Abzweige gebildet wird. Aus der Nennspannung und der Summenkapazität des Netzes kann weiters eine Größe ermittelt werden, welche die Intensität des Umladevorganges beschreibt und als Bezugsgröße für die Bestimmung für den Erfülltheitsgrad p für das Vorliegen der Verfahrensvoraussetzungen genutzt werden kann.

Das oben erläuterte erfindungsgemäße Verfahren weist unter anderem die folgenden Vorteile auf. Das Verfahren ist sowohl für die Auswertung von Erdschlußwischern als auch für die rasche Ortung von stationären Erdschlüssen geeignet. Das Verfahren wertet den transienten Umladevorgang aus und erkennt Erdschlüsse auch, wenn diese ca. 1 bis 2 Millisekunden bestehen (wegen des Fehlerstromintegrals). Es ist nicht notwendig, dass der Erdschlußfall für die ganze erste Periode aufrecht bleibt. Das Fehlerstromintegral über die zweite Periode sagt aus, ob der transiente Umladevorgang schon abgeschlossen ist. Zwecks Erhöhung der Genauigkeit kann im gesunden Netz kontinuierlich das Stromintegral pro Periode und Abzweig bestimmt werden, um Offsetfehler der Hardware zu minimieren.

Das Verfahren funktioniert hingegen nicht im eingeschwungenen Zustand des Erdschlusses, da in diesem Fall das Fehlerstromintegral über eine Periode (Gleichanteil) verschwindet.

Zusammenfassend wird das oben im Detail beschriebene Verfahren nochmals kurz beschrieben:

Beim Wischerverfahren wird der nach einem Erdschlußeintritt stattfindende transiente Umladevorgang des Netzes über die Erdschlußstelle durch zeitlich äquidistante Abtastung der Verlagerungsspannung oder drei Phasen-Erdspannungen sowie aller Nullströme aufgezeichnet und nachfolgend unter Verwendung eines Leitungsmodelles ausgewertet.

Dieses Verfahren wertet bestimmungsgemäß transiente Systemzustände aus und ist im stationären Erdschlußfall nicht anwendbar. Die Ausführung des Verfahrens liefert als Ergebnis einen normierten, zwischen 0 und 1 liegenden, Erfülltheitsgrad der Erdschlußvermutung p(n) für alle N Abzweige mit n gleich 1 bis N.

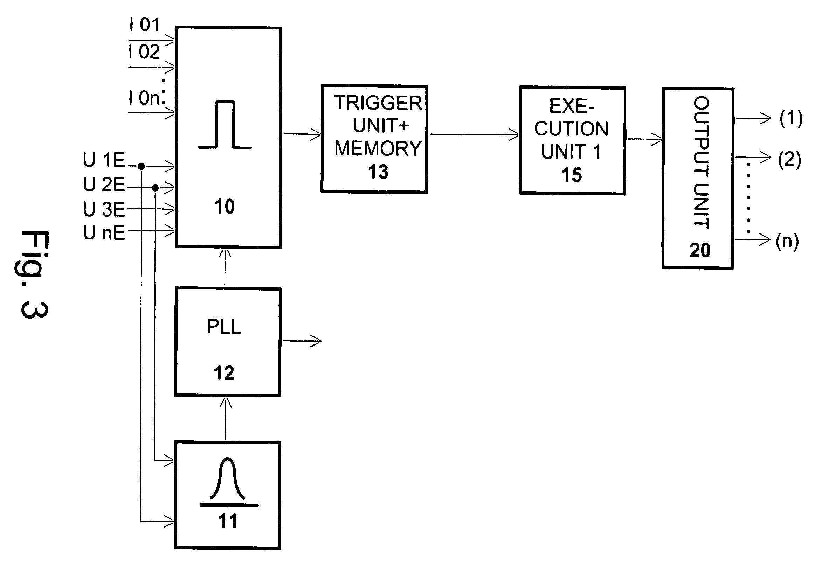

In Figur 3 ist ein Blockschaltbild für ein nicht einschränkendes Ausführungsbeispiel zur Realisierung der erfindungsgemäßen Einrichtung dargestellt.

Die Einrichtung umfaßt eine Abtasteinheit 10, mit welcher die oben beschriebenen, durch entsprechende bekannte Messeinrichtungen und Messwandler gelieferten Messgrößen abgetastet werden können, nämlich die von den Abzweigstromwandlern gelieferten Signale für die Nullströme $i_{on}$ aller Abzweige, die von den Spannungsmesswandlern kommenden Signale für die Phasen-Erdspannungen $U_{1e}$, $U_{2e}$, $U_{3e}$, und/oder das von der Spannungsmesswicklung der Tauchkernspule oder einem zusätzlichen Spannungswandler gelieferte Signal für die Sternpunkt-Erdspannung $U_{ne}$ (Verlagerungsspannung).

Weiters ist eine mit zumindest zwei Signalen für die Phasen-Erdspannung verbundene Synchronisiereinheit 11 vorgesehen, welche zur Bildung einer Phasenreferenz für die Abtasteinheit 10 eingerichtet ist. Diese Phasenreferenz wird an eine PLL-Einheit 12 (phase locked loop) geliefert, welche zur phasensynchronen Vervielfachung der Netzfrequenz dient und ein Ausgangssignal zur Abtastung der Messsignale an die Abtasteinheit 10 liefert.

Die Abgetasteten Messwerte werden vorerst an eine Triggereinheit 13 übermittelt, in welcher die gemessenen Nullströme und die Verlagerungsspannung, bzw. die Phasen-Erdspannungen auf plötzliche Änderungen überwacht werden. Diese Triggereinheit 13 löst bei Überschreiten von vordefinierten Schwellwerten durch eine dieser Messgrößen einen oder mehrere verfahrensbedingt vorgesehene Messwertaufzeichnungszyklen aus. Die aufgezeichneten Messzyklen werden in einem (nicht dargestellten) Speicher hinterlegt.

Die hinterlegten Messwerte werden sodann in einer Auswerteeinheit 15 zur Durchführung des oben beschriebenen Wischerverfahren ausgewertet. Die Einheit 15 liefert im Fall einer getriggerten Aufzeichnung und Auswertung von Messgrößen ein Ergebnis betreffend den Erfülltheitsgrad für das Vorliegen eines Erdschlusses an einem bestimmten Abzweig 1, 2, ... n. Dieser Erfülltheitsgrad wird in der Folge an eine Ausgabeeinheit 20 weitergeleitet, welche z.B. eine Anzeige, einen Alarm, einen Notbetrieb, eine Abschaltung od. dgl. auslöst.

## Patentansprüche

1. Verfahren zur Bestimmung eines erdschlußbehafteten Abzweiges in einem induktiv sternpunktkompensierten elektrischen Stromversorgungsnetz, wobei als Messgrößen zumindest die Verlagerungsspannung $U_{ne}$ oder die Summe der Phasen-Erdspahnungen $U_{1e}$, $U_{2e}$, $U_{3e}$ der einzelnen Phasen $L_1$, $L_2$, $L_3$ und die Nullströme $i_0$ aller Abzweige

oder die Summe der einzelnen Phasenströme $i_1$, $i_2$, $i_3$ dieser Abzweige ausgewählt und gemessen werden, **dadurch gekennzeichnet, dass** der transiente Umladevorgang über eine Erdsthlussstelle ausgewertet wird, indem unter Verwendung eines Leitungsmodells mit konzentrierten Parametern für das elektrische Versorgungsnetz eine funktionale Beziehung zwischen den zeitlichen Integralen der Abzweignullströme $i_0$, bzw. den zeitlichen Integrale der Summe der einzelnen Phasenströme $i_1$, $i_2$, $i_3$,und der Verlagerungsspannung $U_{ne}$, bzw. den Phasen-Erdspannugen $U_{1e}$, $U_{2e}$, $U_{3e}$, hergestellt wird und die durch den transienten Umladevorgang über eine eventuell vorhandene Erdschlussstelle beeinflusste funktionale Beziehung zwischen den zeitlichen Integralen der Abzweignullströme $i_0$, bzw. zeitlichen Integrale der Summe der einzelnen Phasenströme $i_1$, $i_2$, $i_3$, und der Verlagerungsspannung $U_{ne}$, bzw. den Phasen-Erdspannungen $U_{1e}$, $U_{2e}$, $U_{3e}$, zur Bestimmung eines erdschlußbehafteten Abzweiges ausgewertet wird.

2. Verfahren nach Anspruch 1, **dadurch gekennzeichnet, dass** die Auswertung unter Einbeziehung signifikanter Abzweigparameter, z.B. der Summe der ohmschen G und/oder kapazitiven Ableitungen C, durchgeführt wird.

3. Verfahren nach Anspruch 2, **dadurch gekennzeichnet, dass** die zeitlichen Integrale der Verlagerungsspannung $U_{ne}$, bzw. die zeitlichen Integrale des arithmetischen Mittels der Phasen-Erdspannungen $U_{1e}$, $U_{2e}$, $U_{3e}$, vorzugsweise numerisch berechnet, werden und mit der ohmschen Ableitung G gewichtet werden und damit die ermittelten Integrale der Abzweignullströme $i_0$, bzw. die zeitlichen Integrale der Summe der einzelnen Phasenströme $i_1$, $i_2$, $i_3$, korrigiert werden.

4. Verfahren nach einem der Ansprüche 1 bis 3, **dadurch** gekennzeichent, dass die Auswertung anhand der für einen Abzweig geltenden grundlegenden Beziehung

$$I_{ia}(t) \approx \left[\left(I_u(t)\cdot G + dU_{ne}(t)\cdot C\right) + \left(I_{if}(t)\right)\right]$$

mit

$I_{ia}(t)$ Integral von 0 bis t des Stromes $I_{oa}(t)$, der dem mit dem lineare Übertragungsglied H(p) korrigierten Integral von 0 bis t des Nullstromes $I_0(t)$ entspricht,
$I_{it}(t)$ Integral von 0 bis t des Fehlerstromes $I_f(t)$,
$I_{io}(t)$ Integral von 0 bis t des Nullstromes $I_o(t)$
$I_u(t)$ Integral von 0 bis t der Verlagerungsspannung $U_{ne}(t)$ und
$dU_{ne}(t) = U_{ne}(t) - U_{ne}(0)$,
G Summe der ohmschen Ableitungen des Abzweiges,
C Summe der Phasen-Erdkapazitäten des Abzweiges,
H(p) eine für den Abzweig spezifische, gebrochen rationale Übertragungsfunktion des gesunden Abzweiges,

gegebenenfalls im Zeitbereich, durchgeführt wird.

5. Verfahren nach einem der Ansprüche 1 bis 4, **dadurch gekennzeichnet, dass** zur Auswertung der Gleichanteil bzw der Absolutbetrag des Gleichanteils eines Fehlerstromintegrales für die Abzweige berechnet wird.

6. Verfahren nach Anspruch 5, **dadurch gekennzeichnet, dass** die Nullstromintegrale zu paarweisen, nach dem Fehlereintritt gelegenen Zeitpunkten berechnet werden, bei welchen die Verlagerungsspannung $U_{ne}$ gleich Null ist, und der Gleichanteil des Fehlerstromitegrales aus diesem zu diesen Zeitpunkten ermittelten Nullstromintegral-Wertepaar gebildet wird.

7. Verfahren nach Anspruch 6, **dadurch gekennzeichnet, dass** der Gleichanteil des Fehlerstromintegrals als arithmetisches Mittel der ermittelten Nullstromintegral-Wertepaare gebildet wird.

8. Verfahren nach Anspruch, 5, 6 oder 7, **dadurch gekennzeichnet, dass** ein Abzweig als erdschlussbehaftet erkannt wird, wenn ein Gleichanteil des ermittelten Fehlerstromintegrals vorhanden ist bzw. dessen Absolutbetrag des Gleichanteils am größten ist.

9. Verfahren nach einem der Ansprüche 2 bis 8, **dadurch gekennzeichnet, dass** zumindest ein signifikanter Abzweigparameter im erdschlußfreien Fall bestimmt werden.

**10.** Verfahren nach Anspruch 9, **dadurch gekennzeichnet, dass** zumindest ein signifikanter Abzweigparameter im erdschlußfreien Fall aus zwei unterschiedlichen Verlagerungsspannungen $U_{ne}$, z.B. bei zwei verschiedenen Stellungen einer Löschspule, bestimmt werden, wobei die Summe der ohmschen G und/oder der kapazitiven Ableitungen C durch Fourierreihenentwicklung der Grundwellenanteile obiger Messgrößen berechnet werden und allenfalls eine Leitungsübertragungsfunktion aus der Fourierreihenentwicklung der Grundwelle sowie zumindest einer Oberwelle der ausgewählten Messgrößen bestimmt wird.

**11.** Verfahren nach einem der Ansprüche 1 bis 9, **dadurch gekennzeichnet, dass** ein Erfülltheitsgrad p für das Vorliegen eines Erdschlusses ermittelt wird.

**12.** Verfahren nach Anspruch 11, **dadurch gekennzeichnet, dass** der Erfülltheitsgrad p mittels einer relativen Fehlerfunktion, z.B. der Absolutbetrag des Gleichanteils des Fehlerstromintegrales bezogen auf die Summe der Absolutbeträge der Gleichanteile aller Abzweige, festgelegt wird, und vorzgsweise auf Werte zwischen null und eins normiert wird.

**13.** Verfahren nach Anspruch 11 oder 12, **dadurch gekennzeichnet, dass** das Vorliegen eines fehlerhaften Abzweigs als wahrscheinlich erkannt wird, je näher der Erfülltheitsgrad bei eins liegt.

**14.** Vorrichtung zur Bestimmung eines erdschlußbehafteten Abzweiges in einem induktiv sternpunktkompensierten elektrischen Stromversorgungsnetz mit einer Einrichtung zum Messen der Verlagerungsspaanung $U_{ne}$ oder die Summe der Pha$em.Erdspannun9.en $U_{1e}$; $U_{2e}$, $U_{3e}$,der einzelnen Phasen; $L_1$, $L_2$, $L_3$ und der Nuttströme $i_0$ aller Abzweige oder die Summe der einzelnen Phasenströme $i_1$, $i_2$, $i_3$ Abzweige und einer Auswerteeinheit zur Auswertung dieser Messgrößen, wobei die Auswerteeinheit(10, 11, 12, 13) eine Anzeigeeinrichtung und eine Verarbeitungseinheit (15) zur Auswertung der Messgrößen aufweist, **dadurch gekennzeichnet, dass** in der Verarbeitühgseinheit (15) unter Verwendung eines Leitungsmodells mit konzentrierten Parametern des Versorgungsnetzes eine funktionale Beziehung zwischen den zeitlichen Integralen der Abzweignullströme $i_0$, bzw den zeitlichen Integralen der Summe der einzelnen Phasenströme $i_1$, $i_2$, $i_3$, und der Verlagerungsspannung $U_{ne}$, bzw den Phasen-Erdspannungen $U_{1e}$, $U_{2e}$, $U_{3e}$, implementiert ist und die Verarbeitungseinheit (15) dazu eingerichtet ist, anhand dieses funktionalen Zusammenhangs und der Messgrößen für jeden Abzweig des Versorgungsnetzes einen Erfülltheitsgrad für das Vorliegen eines Erdschlusses zu ermitteln, indem die Verarbeitungseinheit (15) dazu eingerichtet ist, für jeden Abzweig zur Auswertung des transienten Umladevorgangs der Phasen-Erdkapazitäten $C_E$ über eine Erdschlussstelle unmittelbar nach Eintritt eines Erdschlusses, die durch den transienten Umladevorgang über eine eventuell vorhandene Erdschlussstelle beeinflusste funktionale Beziehung zwischen den zeitlichen Integralen der Abzweignullströme $i_0$, bzw. zeitlichen Integralen der Summe der einzelnen Phasenströme $i_1$, $i_2$, $i_3$, und der Verlagerungsspannung $U_{ne}$ oder der Phasen-Erdspannungen $U_{1e}$, $U_{2e}$, $U_{3e}$, auszuwerten, gegebenenfalls unter Einbeziehung von Messgrößen, die vor Eintritt des Erdschlusses ermittelt werden.

**Claims**

**1.** A method for determining an earth-faulted branch in an inductive neutral point-compensated electrical power supply network, wherein
as measured quantities at least the biasing voltage $U_{ne}$ or the sum of the phase-to-earth voltages $U_{1e}$, $U_{2e}$, $U_{3e}$ of the individual phases $L_1$, $L_2$, $L_3$ and the zero currents $i_0$) of all branches or the sum of the individual phase currents $i_1$, $i_2$, $i_3$ are selected and measured,
**characterised in that** the transient load transfer process is evaluated via an earth fault location, **in that** with the use of a transmission line model with concentrated parameters for the electrical supply network a functional relationship is produced between the timewise integrals of the branch zero currents $i_0$, or the timewise integrals of the sum of the individual phase currents $i_1$, $i_2$, $i_3$, and the biasing voltage $U_{ne}$, or the phase-to-earth voltages $U_{ne}$, and the functional relationship, influenced by the transient load transfer process via an earth fault location that may be present, between the timewise integrals of the branch zero currents $i_0$, or timewise integrals of the sum of the individual phase currents $i_1$, $i_2$, $i_3$, and the biasing voltage $U_{ne}$ or the phase-to-earth voltages $U_{1e}$, $U_{2e}$, $U_{3e}$, is evaluated to determine an earth-faulted branch.

**2.** The method according to Claim 1,
**characterised in that** the evaluation is carried out with the inclusion of significant branch parameters, e.g. the sum of the resistive G and/or capacitive C dissipations.

3. The method according to Claim 2,
**characterised in that** the timewise integrals of the biasing voltage $U_{ne}$, or the timewise integrals of the arithmetic mean of the phase-to-earth voltages $U_{1e}$, $U_{2e}$, $U_{3e}$, are preferably numerically calculated, and weighted with the resistive dissipation G, and therewith the determined integrals of the branch zero currents $i_0$, or the timewise integrals of the sum of the individual phase currents $i_1$, $i_2$, $i_3$, are corrected.

4. The method according to one of the Claims 1 to 3,
**characterised in that** the evaluation is carried out on the basis of the basic relationship applicable for a branch

$$I_{ia}(t) \approx [(I_n(t)\ G + dU_{ne}(t)\ C) + (I_{if}(t)]$$

where

$I_{ia}(t)$ is the integral from 0 to t of the current $I_{0a}(t)$, which corresponds to the integral from 0 to t of the zero current $I_0(t)$ corrected with the linear transfer element H(p),
$I_{if}(t)$ is the integral from 0 to t of the fault current $I_f(t)$,
$I_{i0}(t)$ is the integral from 0 to t of the zero current $I_0(t)$,
$I_U(t)$ is the integral from 0 to t of the biasing voltage $U_{ne}(t)$ and
$dU_{ne}(t) = U_{ne}(t) - U_{ne}(0)$,
G is the sum of the resistive dissipations of the branch,
C is the sum of the phase-to-earth capacitances of the branch,
H(p) is a rational transfer function of the sound branch, specific for the branch, if necessary in the time domain.

5. The method according to one of the Claims 1 to 4,
**characterised in that** for the evaluation of the constant component, or the absolute value of the constant component, a fault current integral is calculated for the branches.

6. The method according to Claim 5,
**characterised in that** the zero current integrals are calculated to points in time situated in pairs after the fault occurrence, at which the biasing voltage $U_{ne}$ is equal to zero, and the constant component of the fault current integral is formed from this zero current integral pair of values, determined to these points in time.

7. The method according to Claim 6,
**characterised in that** the constant component of the fault current integral is formed as the arithmetic mean of the determined zero current integral pair of values.

8. The method according to Claim 5, 6 or 7,
**characterised in that** a branch is detected as earth-faulted if a constant component of the determined fault current integral is present, or its absolute value of the constant component is a maximum.

9. The method according to one of the Claims 2 to 8,
**characterised in that** at least one significant branch parameter is determined in the earth fault-free case.

10. The method according to Claim 9,
**characterised in that** at least one significant branch parameter is determined in the earth fault-free case from two different biasing voltage $U_{ne}$, e.g. with two different positions of an extinguishing coil, wherein the sum of the resistive dissipation G and/or the capacitive dissipations C are calculated by means of a Fourier series development of the fundamental wave components of the above-measured quantities, and, if need be, a power transfer function from the Fourier series development of the fundamental wave, and also at least one harmonic of the selected measured quantities, is determined.

11. The method according to one of the Claims 1 to 9,
**characterised in that** a degree of fulfilment p is determined for the presence of an earth fault.

12. The method according to Claim 11,
**characterised in that** the degree of fulfilment p is determined by means of a relative fault function, e.g. the absolute value of the constant component of the fault current integral relative to the sum of the absolute values of the constant components of all branches, and preferably is normalised to values between zero and one.

13. The method according to Claim 11 or 12, **characterised in that** the presence of a faulty branch is detected as probable, the closer the degree of fulfilment lies to one.

14. A device for determining an earth-faulted branch in an inductive neutral point-compensated electrical power supply network with an item of equipment for the measurement of the biasing voltage $U_{ne}$, or the sum of the phase-to-earth voltages $U_{1e}$, $U_{2e}$, $U_{3e}$ of the individual phases $L_1$, $L_2$, $L_3$, and the zero currents $i_0$ of all branches, or the sum of the individual phase currents $i_1$, $i_2$, $i_3$ of these branches, wherein
the evaluation unit (10, 11, 12, 13) has a display device and a processing unit (15) for the evaluation of the measured quantities,
**characterised in that** in the processing unit (15) with the use of a transmission line model with concentrated parameters of the electrical supply network a functional relationship is implemented between the timewise integrals of the branch zero currents $i_0$, or the timewise integral of the sum of the individual phase currents $i_1$, $i_2$, $i_3$, and the biasing voltage $U_{ne}$, or the phase-to-earth voltages $U_{1e}$, $U_{2e}$, $U_{3e}$, and the processing unit (15) for this purpose is equipped to determine on the basis of this functional relationship and the measured quantities for each branch of the supply network a degree of fulfilment for the presence of an earth fault, **in that** the processing unit (15) for this purpose is equipped for each branch for the evaluation of the transient load transfer process of the phase-to-earth capacitances CE via an earth fault location immediately after occurrence of an earth fault to evaluate the functional relationship, influenced by the transient load transfer process via an earth fault location that may be present, between the timewise integrals of the branch zero currents $i_0$, or timewise integrals of the sum of the individual phase currents $i_1$, $i_2$, $i_3$, and the biasing voltage $U_{ne}$ or the phase-to-earth voltages $U_{1e}$, $U_{2e}$, $U_{3e}$, if necessary with the incorporation of measured quantities that are determined before the occurrence of the earth fault.

**Revendications**

1. Procédé pour la détection d'un branchement présentant une perte à la terre dans un réseau de distribution électrique compensé par induction au point neutre, dans lequel l'on choisit et l'on mesure comme grandeurs de mesure au moins la tension de décalage $U_{ne}$ ou la somme des tensions de la phase à la terre $U_{1e}$, $U_{2e}$, $U_{3e}$ des différentes phases $L_1$, $L_2$, $L_3$ et les intensités à zéro $i_0$ de tous les branchements ou la somme des différentes intensités des phases $i_1$, $i_2$, $i_3$ de ces branchements, **caractérisé en ce que** le processus transitoire de changement de charge à travers un point de perte à la terre est évalué **en ce que**, moyennant l'utilisation d'un modèle de conducteurs avec des paramètres concentrés pour le réseau de distribution électrique, une relation fonctionnelle est construite entre les intégrales en fonction du temps des intensités à zéro $i_0$ des branchements, respectivement les intégrales en fonction du temps de la somme des différentes intensités de phase $i_1$, $i_2$, $i_3$, et la tension de décalage $U_{ne}$, respectivement les tensions des phases à la terre $U_{1e}$, $U_{2e}$, $U_{3e}$, et la relation fonctionnelle, influencée par le processus transitoire de changement de charge à travers un point de perte à la terre éventuellement existant, entre les intégrales en fonction du temps des intensités à zéro $i_0$ des branchements, respectivement les intégrales en fonction du temps de la somme des différentes intensités de phase $i_1$, $i_2$, $i_3$, et la tension de décalage $U_{ne}$, respectivement les tensions à la terre des phases $U_{1e}$, $U_{2e}$, $U_{3e}$, est évaluée pour la détermination d'un branchement présentant une perte à la terre.

2. Procédé selon la revendication 1, **caractérisé en ce que** l'évaluation est effectuée en faisant appel à des paramètres significatifs des branchements, par exemple à la somme des conducteurs partants ohmiques G et/ou capacitifs C.

3. Procédé selon la revendication 2, **caractérisé en ce que** les intégrales en fonction du temps de la tension de décalage $U_{ne}$, respectivement les intégrales en fonction du temps de la moyenne arithmétique des tensions entre les phases et la terre $U_{1e}$, $U_{2e}$, $U_{3e}$ sont calculées, de préférence numériquement, et sont pondérées par le conducteur partant ohmique G, et **en ce qu'**avec ces dernières, les intégrales déterminées des intensités à zéro $i_0$ des branchements, respectivement les intégrales en fonction du temps de la somme des différentes intensités des phases $i_1$, $i_2$, $i_3$, sont corrigées.

4. Procédé selon l'une quelconque des revendications 1 à 3, **caractérisé en ce que** l'évaluation est exécutée, le cas échéant dans le domaine temporel, à l'aide de la relation fondamentale applicable pour un branchement

$$I_{ia}(t) \approx [(I_u(t) \bullet G + dU_{ne}(t) \bullet C) + (I_{if}(t))]$$

avec

$I_{ia}(t)$ intégrale de 0 à t de l'intensité $I_{0a}(t)$, qui correspond à l'intégrale de 0 à t, corrigée par l'élément de transfert linéaire H(p), de l'intensité à zéro $I_0(t)$,

$I_{if}(t)$ intégrale de 0 à t de l'intensité du courant de défaut $I_f(t)$,

$I_{i0}(t)$ intégrale de 0 à t de l'intensité à zéro $I_0(t)$

$I_u(t)$ intégrale de 0 à t de la tension de décalage $U_{ne}(t)$ et

$dU_{ne}(t) = U_{ne}(t) - U_{ne}(0)$.

G somme des conducteurs partants ohmiques du branchement,

C somme des capacités entre les phases et la terre du branchement,

H(p) une fonction de transfert rationnelle fractionnaire du branchement sain, spécifique pour le branchement.

**5.** Procédé selon l'une quelconque des revendications 1 à 4, **caractérisé en ce que** pour l'évaluation, la composante de courant continu, respectivement le module en valeur absolue de la composante de courant continu d'une intégrale du courant de défaut, est calculé pour le branchement.

**6.** Procédé selon la revendication 5, **caractérisé en ce que** les intégrales de l'intensité à zéro sont calculées à des paires d'instants, situées après la survenue du défaut, auxquelles la tension de décalage $U_{ne}$ est égale à zéro, et **en ce que** la composante de courant continu de l'intégrale du courant de défaut est formée à partir de cette paire de valeurs de l'intégrale de l'intensité à zéro, déterminée à ces instants.

**7.** Procédé selon la revendication 6, **caractérisé en ce que** la composante de courant continu de l'intégrale du courant de défaut est formée comme moyenne arithmétique des paires de valeur déterminées de l'intégrale de l'intensité à zéro.

**8.** Procédé selon l'une quelconque des revendications 5, 6 ou 7, **caractérisé en ce qu'**un branchement est reconnu comme présentant une perte à la terre quand il y a une composante de courant continu de l'intégrale du courant de défaut déterminée, respectivement quand sa valeur absolue de la composante de courant continu est la plus grande.

**9.** Procédé selon l'une quelconque des revendications 2 à 8, **caractérisé en ce qu'**au moins un paramètre significatif du branchement est déterminé dans le cas sans perte à la terre.

**10.** Procédé selon la revendication 9, **caractérisé en ce qu'**au moins un paramètre significatif du branchement dans le cas sans perte à la terre est déterminé à partir de deux tensions de décalage $U_{ne}$ différentes, par exemple en deux positions différentes d'une bobine souffleuse d'étincelles, sachant que la somme des conducteurs partants ohmiques G et/ou capacitifs C est calculée par développement en série de Fourier des composantes de l'onde fondamentale des grandeurs de mesure ci-dessus et que tout au plus une fonction de transfert de conducteur est déterminée à partir du développement en série de Fourier de l'onde fondamentale ainsi qu'au moins d'une harmonique de la grandeur de mesure choisie.

**11.** Procédé selon l'une quelconque des revendications 1 à 9, **caractérisé en ce qu'**un degré de satisfaction p est déterminé pour l'existence d'une perte à la terre.

**12.** Procédé selon la revendication 11, **caractérisé en ce que** le degré de satisfaction p est fixé au moyen d'une fonction d'erreur relative, par exemple la valeur absolue de la composante de courant continu de l'intégrale du courant de défaut, rapportée à la somme des valeurs absolues des composantes de courant continu de tous les branchements, et est normé de préférence à des valeurs entre zéro et un.

**13.** Procédé selon l'une quelconque des revendications 11 ou 12, **caractérisé en ce que** la présence d'un branchement défectueux est reconnue comme probable plus le degré de satisfaction est proche de un.

**14.** Dispositif pour la détection d'un branchement présentant une perte à la terre dans un réseau de distribution électrique compensé par induction au point neutre, avec un dispositif pour la mesure de la tension de décalage $U_{ne}$ ou de la

somme des tensions de la phase à la terre $U_{1e}$, $U_{2e}$, $U_{3e}$ des différentes phases $L_1$, $L_2$, $L_3$ et des intensités à zéro $i_0$ de tous les branchements ou de la somme des différentes intensités des phases $i_1$, $i_2$, $i_3$ de ces branchements, et avec un dispositif d'évaluation de ces grandeurs de mesure, dans lequel l'unité d'évaluation (10, 11, 12, 13) comporte un dispositif d'affichage et une unité de traitement (15) pour l'évaluation des grandeurs de mesure, **caractérisé en ce que** dans l'unité de traitement (15), moyennant l'utilisation d'un modèle de conducteurs avec des paramètres concentrés du réseau de distribution, une relation fonctionnelle est implémentée entre les intégrales en fonction du temps des intensités à zéro $i_0$ des branchements, respectivement les intégrales en fonction du temps des sommes des différentes intensités des phases $i_1$, $i_2$, $i_3$ et de la tension de décalage $U_{ne}$, respectivement des tensions entre les phases et la terre $U_{1e}$, $U_{2e}$, $U_{3e}$, et l'unité de traitement (15) est conçue pour déterminer au vu de ce contexte fonctionnel et des grandeurs de mesure pour chaque branchement du réseau de distribution un degré de satisfaction pour la présence d'une perte à la terre, **en ce que** l'unité de traitement (15) est conçue pour évaluer pour chaque branchement, pour l'évaluation du processus transitoire de changement de charge des capacités entre les phases et la terre $C_E$ par un contact à la terre, directement après la survenue d'une perte à la terre, la relation fonctionnelle, influencée par le processus transitoire de changement de charge par un contact à la terre éventuellement existant, entre les intégrales en fonction du temps des intensités à zéro $i_0$ des branchements, respectivement les intégrales en fonction du temps de la somme des différentes intensités des phases $i_1$, $i_2$, $i_3$, et la tension de décalage $U_{ne}$ ou les tensions entre les phases et la terre $U_{1e}$, $U_{2e}$, $U_{3e}$, le cas échéant en faisant appel à des grandeurs de mesure qui auront été déterminées avant la survenue de la perte à la terre.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9218872 A
- EP 82103 A
- DE 2711629
- WO 9627138 A
- EP 267500 A1
- US 5839093 A
- US 4351011 A